# EUROPÄISCHE PATENTSCHRIFT

(11) **EP 3 853 883 B1**
(45) Veröffentlichungstag und Bekanntmachung des Hinweises auf die Patenterteilung: **27.04.2022**
(21) Anmeldenummer: 20726012.6
(22) Anmeldetag: 08.05.2020
(51) Int. Cl.: H01L 21/3213, H01L 21/768

(54) **VERFAHREN ZUM STRUKTURIEREN EINES SUBSTRATS**
METHOD FOR STRUCTURING A SUBSTRATE
PROCÉDÉ DE STRUCTURATION D'UN SUBSTRAT

(30) Priorität: 08.05.2019 DE 102019112030
(43) Veröffentlichungstag der Anmeldung: 28.07.2021
(73) Patentinhaber: LSR Engineering & Consulting Limited, Kowloon, Hong Kong SAR (HK)
(72) Erfinder: LANG, Marcus Elmar, Chongqing, 404100 (CN)
(74) Vertreter: Baur & Weber Patentanwälte PartG mbB
(86) Internationale Anmeldenummer: PCT/EP2020/062843
(87) Internationale Veröffentlichungsnummer: WO 2020/225414

(56) Entgegenhaltungen:
- WO-A1-2015/063080
- WO-A1-2018/135325

## Beschreibung

Die Erfindung betrifft ein Verfahren zum Strukturieren eines Substrats, insbesondere ein Strukturieren mittels selektiven Ätzens in der Halbleiter- und IC-Substratindustrie.

Aus dem allgemeinen Stand der Technik ist es bekannt, auf isolierenden Substraten metallische Schichten aufzubringen, die anschließend mittels einer nasschemischen Ätzung strukturiert werden. So sind beispielsweise Substrate mit Kupferschichten bekannt, wobei hier typischerweise zunächst eine Keimschicht (dem englischen Sprachgebrauch folgend häufig auch als Seedlayer bezeichnet) elektrochemisch als Kristallisationskeim abgeschieden wird. Auf dieser elektrochemisch abgeschiedenen Kupferschicht wird anschließend eine weiterer elektrolytisch abgeschiedene Kupferschicht aufgebracht, wobei die beiden Kupferschichten nachträglich gemeinsam strukturiert werden, um die für eine Verdrahtung gewünschte Leiterbahnelemente zu bilden. Weitere Prozess-Schritte, wie das Bilden von Durchkontaktierungen, können ebenfalls notwendig sein und sind dem Fachmann bekannt.

Typischerweise werden die strukturierten Leiterbahnelemente bezüglich ihrer minimalen Strukturbreite sowie des minimalen Abstands zueinander charakterisiert. Gegenwärtig ist in der Galvanotechnik das Bilden von Strukturen mit 8 µm minimaler Strukturauflösung bei minimalem Abstand benachbarter Strukturen in etwa der gleichen Größenordnung in der Substratindustrie üblich.

In gegenwärtigen Weiterentwicklungen, die dem Trend der immer größer werdenden Miniaturisierung folgen, wird angestrebt, minimale Strukturbreiten bzw. Abstände in den Bereich von 5 µm oder 2 µm oder auch noch kleiner zu reduzieren. Dazu ist es jedoch erforderlich, eine entsprechende Weiterentwicklung auch bezüglich der Ätztechnik zu schaffen, um insbesondere die auftretenden Unterätzungen während des Bildens der Strukturen zu verringern.

Ein Ansatz könnte dahin gehen, die Keimschicht, d. h. den Seedlayer, gegen ein anderes Metall auszutauschen, um selektiv Ätzen zu können, was insbesondere einen geringeren nasschemischen Angriff auf die abgeschiedene elektrolytische Kupferschicht möglich macht.

Eine mögliche Variante könnte hierbei der Einsatz von Titan als Keimschicht sein, wobei die Titanschicht typischerweise mit einer Schichtstärke von 300 nm oder weniger auf das Substrat aufgebracht wird. Bei bekannten Verfahren erfolgt dann ein Ätzen der Titanschicht mit Flusssäure oder mit einer alkalischen Lösung, d. h. insbesondere NaOH oder KOH, wobei häufig in Verbindung mit Wasserstoffperoxid gearbeitet wird.

Beide Verfahren, d. h. sowohl das Ätzen des Titans mit Flusssäure als auch in einer alkalischen Lösung, sind jedoch abhängig vom Lösungsaustausch zwischen den Strukturen und weisen darüber hinaus prozesstechnisch einen großen Nachteil dahingehend auf, dass extrem gefährliche Prozessbedingungen geschaffen werden. Neben der stark ätzenden Wirkung, die sowohl für die verwendeten Maschinen aber auch dem Bedienpersonal sowie der Umwelt negative Einflüsse ausüben könnte, besteht insbesondere bei dieser Prozessführung auch eine Explosionsgefahr durch plötzlichen Abbau einzelner Reaktionsbestandteile (oftmals als "sudden decomposition" bezeichnet), was insbesondere bei der Verwendung von KOH eine Rolle spielt.

Aus der EP 2 549 553 A2 ist ein LED-Modul und ein entsprechendes Herstellungsverfahren bekannt, bei dem das LED-Modul mehrere Masseflächen aufweist, die auf einer isolierenden Schicht gebildet werden. Die isolierende Schicht kann beispielsweise als oxidiertes Silizium bereitgestellt werden. Auf die Isolationsschicht wird eine Keimschicht aufgebracht, die Titan oder Gold als Startschicht aufweist.

Aus WO 2018 135325 ist ein Verfahren zum Strukturieren einer Titan-Keimschicht bekannt.

Aufgabe der Erfindung ist es nun, ein Verfahren zum Strukturieren eines Substrats, insbesondere ein Strukturieren mittels selektiven Ätzens in der Halbleiter- und IC-Substratindustrie zu schaffen, das bezüglich der Prozessbedingungen leichter beherrschbar ist als die aus dem Stand der Technik bekannten Verfahren und darüber hinaus Strukturauflösungen von 2 µm oder weniger ermöglicht.

Diese Aufgabe wird durch die Merkmale des Anspruchs 1 gelöst. Weitere vorteilhafte Ausgestaltungen der Erfindung sind jeweils Gegenstand der Unteransprüche. Diese können in technologisch sinnvoller Weise miteinander kombiniert werden. Die Beschreibung, insbesondere im Zusammenhang mit der Zeichnung, charakterisiert und spezifiziert die Erfindung zusätzlich.

Gemäß der Erfindung wird ein Verfahren zum Strukturieren eines Substrats angegeben, insbesondere ein Strukturieren mittels selektiven Ätzens in der Halbleiter- und IC-Substratindustrie, bei dem folgende Schritte ausgeführt werden:
- Bereitstellen eines Substrats,
- Aufbringen einer Titan-Keimschicht auf das Substrat,
- vollflächiges Beschichten des Substrats mit der Titan-Keimschicht mit einer Photoresistschicht,
- lithografische Strukturierung der Photoresistschicht, um Bereiche der Titan-Keimschicht freizulegen,
- selektives Aufbringen von Kupfer als Leiterbahnen in diejenigen Bereiche, in denen die Titan-Keimschicht freigelegt ist,
- Entfernen des strukturierten Photoresists, und
- Ätzen der Titan-Keimschicht in den vormals von dem strukturierten Photoresist bedeckten Bereichen, wobei zum Ätzen der Titan-Keimschicht Phosphorsäure verwendet wird, und darüber hinaus während des Ätzens des Titans eine Belichtung mit UV-Licht erfolgt.

Demnach wird ein Ätzen des Titan-Seedlayers mittels einer Phosphorsäure in einer wässrigen Lösung verwendet, das zusätzlich durch eine Belichtung mit UV-Licht beeinflusst wird, so dass ein zum Kupfermaterial der Leiterbahnen selektives Ätzen durchführbar ist. Eine derartige Vorgehensweise erzeugt deutlich weniger Hinterschneidungen bzw. Unterätzungen, so dass geringere Leiterbahnenbreiten sowie Abstände der Leiterbahnen zueinander erreicht werden können.

Gemäß einer Ausführungsform der Erfindung weist die Titan-Keimschicht eine Schichtdicke von 100 bis 300 nm auf und wird mittels eines Abscheidens aus der Gasphase, vorzugsweise mittels Sputtern erzeugt.

Dies ermöglicht ein einfaches Aufbringen der Titan-Keimschicht auf nahezu allen bekannten Substraten.

Gemäß einer weiteren Ausführungsform der Erfindung wird die Kupferschicht mittels Elektroplattieren aufgebracht.

Die Kupferschicht kann zur Definition der Leiterbahnstrukturen direkt zwischen die von dem strukturierten Photoresist bedeckten Bereichen aufgebracht werden.

Gemäß einer weiteren Ausführungsform der Erfindung weist das UV-Licht eine Wellenlänge von 300 nm oder weniger auf. Typischerweise kann eine UV-Lampe oder ein UV-Laser mit einer Wellenlänge von 185 nm, 254 nm oder einer Kombination beider Wellenlängen verwendet werden.

Aufgrund der Bestrahlung mit UV-Licht wird Sauerstoff bzw. Ozon in der Ätzlösung generiert. Desweiteren bewirkt das UV-Licht eine Aktivierung des Titans, insbesondere durch Oxidation zu Titanoxid, was eine direkte chemische Reaktion in der Diffusionsschicht ermöglicht, so dass sich die Notwendigkeit des Lösungsmittelaustauschs minimiert. Desweiteren unterstützt das UV-Licht ein Abspalten von OH aus der Phosphorsäure, so dass die abgespaltene OH-Gruppe das Ätzen von Titan unterstützt.

Gemäß einer weiteren Ausführungsform der Erfindung wird im Anschluss an das Ätzen ein Hochdruckspülvorgang angewendet.

Demnach wird zur Steigerung der Prozesssicherheit ein Spülvorgang in einer Hochdruckspüle durchgeführt, um noch anhaftende Titanverbindungen lösen zu können.

Gemäß einer weiteren Ausführungsform der Erfindung erfolgt das Ätzen der Titan-Keimschicht durch ein Eintauchen in ein Becken mit Phosphorsäure oder durch Besprühen mit Phosphorsäure.

Somit kann der Ätzvorgang auf unterschiedliche Weise ausgeführt werden, d.h. sowohl durch statisches oder bewegtes Tauchen als auch durch Sprühen, was vielfältige Anwendungsmöglichkeiten schafft.

Gemäß einer weiteren Ausführungsform der Erfindung wird ein zusätzliches Oxidationsmittel hinzugefügt.

Gemäß einer weiteren Ausführungsform der Erfindung wird das Oxidationsmittel in flüssiger Form, vorzugsweise als Wasserstoffperoxid oder in Gasform, vorzugsweise als Sauerstoff oder Ozon hinzugefügt.

Gemäß einer weiteren Ausführungsform der Erfindung wird das Oxidationsmittel als Starter bei Neuansatz oder längerer Standzeit zugefügt.

Gemäß einer weiteren Ausführungsform der Erfindung wird das zusätzliche Oxidationsmittel zur Prozessbeschleunigung hinzugefügt.

Die Zugabe des zusätzlichen Oxidationsmittels ermöglicht es, bei Neuansatz oder längerer Standzeit der Lösung mit der Phosphorsäure als Starter zu dienen. Desweiteren ist es aber auch möglich, das zusätzliche Oxidationsmittel zur Prozessbeschleunigung einzusetzen.

Gemäß einer weiteren Ausführungsform der Erfindung wird zusätzlich eine Ultraschall-Behandlung durchgeführt.

Insbesondere bei der Tauchanwendung kann dadurch eine verbesserte Abfuhr des verbrauchten Materials erfolgen bzw. noch anhaftende Titanverbindungen gelöst.

Gemäß einer weiteren Ausführungsform der Erfindung wird das Lösungsmittel mit der Phosphorsäure einer Saugeinrichtung zugeführt.

In der Tauch- und Sprühanwendung könnte das Anbringen einer oder mehrerer Saugeinrichtungen die Strömung und damit den Lösungsaustausch in ganz feinen Strukturen auf dem Substrat verbessern. Die Kombination aus Spritzen bzw. Strömen (im Tauchen) und der Lösungsabsaugung generiert eine Strömung an der Oberfläche der Strukturen und fördert den Lösungsaustausch.

Nachfolgend werden einige Ausführungsbeispiele anhand der Zeichnung näher erläutert: Es zeigen:
- Fig. 1A - F: einzelne Prozess-Schritte bei der Strukturierung einer leitenden Oberfläche eines Substrats mittels des erfindungsgemäßen Verfahrens in einer Seitenansicht,
- Fig. 2: eine erste Vorrichtung zur Durchführung des erfindungsgemäßen Verfahrens in einer Seitenansicht, und
- Fig. 3: eine zweite Vorrichtung zur Durchführung des erfindungsgemäßen Verfahrens in einer Seitenansicht.

In den Figuren sind gleiche oder funktional gleich wirkende Bauteile mit den gleichen Bezugszeichen versehen.

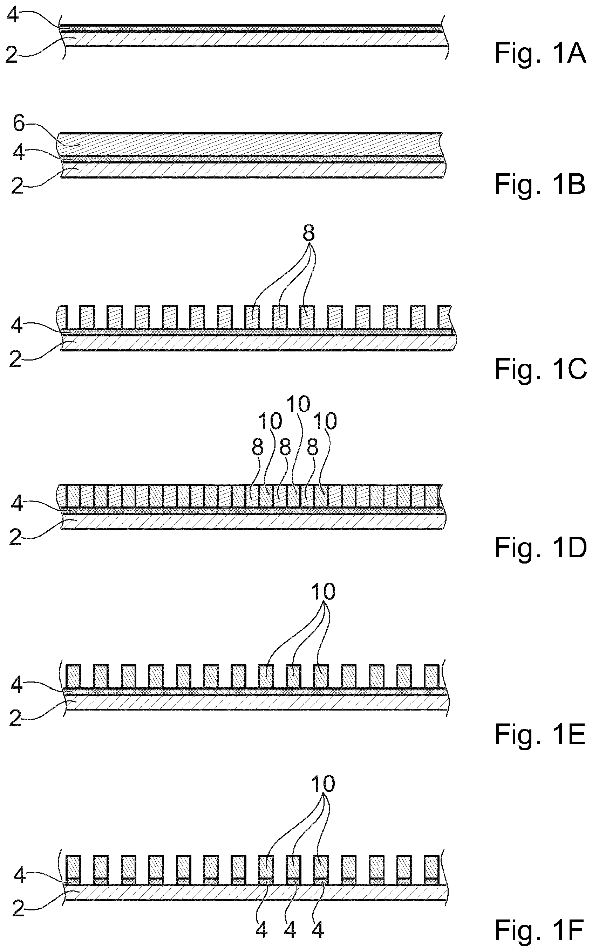

Im Folgenden wird unter Bezugnahme auf die Figuren 1A bis 1F eine erste Ausführungsform der Erfindung näher erläutert, die sich beispielsweise zur Herstellung von strukturierten leitenden Oberflächen für Substrate eignet, auf die integrierte Schaltungen montiert werden.

Wie in Figur 1A gezeigt ist, wird zunächst auf ein Substrat 2 eine Titan-Keimschicht 4 aufgebracht, die üblicherweise eine Dicke von 300 nm oder weniger aufweist und mittels Sputtern auf dem Substrat 2 erzeugt wird. Die Titan-Keimschicht 4 wird nachfolgend auch als Seedlayer bezeichnet werden.

In Figur 1B ist gezeigt, dass auf die Titan-Keimschicht 4 auf der vom Substrat 2 abgewandten Seite nun vollflächig eine Photoresistschicht 6 aufgebracht wird, was üblicherweise durch Aufschleudern oder Laminieren erreicht werden kann. Andere, dem Fachmann bekannte Verfahren zum Aufbringen einer vollflächigen Photoresistschicht 6 sind aber nicht ausgeschlossen.

Wie in Figur 1C gezeigt ist, erfolgt nachfolgend die Strukturierung der Photoresistschicht 6 mittels einer lithografischen Belichtung, so dass nach einem üblicherweise nasschemischen Entwicklungsschritt die vollflächige Photoresistschicht 6 in einen strukturierten Photoresist 8 mit einer Vielzahl von Strukturelementen umgewandelt wird. Der verbliebene Teil des strukturierten Photoresists 8 entspricht in späterer Anwendung denjenigen Positionen, die außerhalb derjenigen liegen, die mit leitfähigen Bahnen auf dem Substrat 2 versehen werden sollen. Es versteht sich daher von selbst, dass der strukturierte Photoresist 8 auch andere, insbesondere auch unregelmäßige Muster bilden kann, die stark von der symbolisch in Figur 1C gezeigten Ausführungsform abweichen können.

In einem nachfolgenden Prozessschritt wird oberhalb der Titan-Keimschicht 4 in den nicht vom strukturierten Photoresist 8 bedeckten Bereichen selektiv Kupfer eingebracht, was üblicherweise mittels Elektroplattieren erfolgt. Die Leiterbahnen werden in Figur 1D mit dem Bezugszeichen 10 gekennzeichnet.

In einem nächsten Prozessschritt, der in Figur 1E gezeigt ist, wird der strukturierte Photoresist 8 entfernt. Folglich sind nun die Bereiche zwischen den Leiterbahnen 10, die durch das Kupfermaterial gebildet werden, frei gelegt, so dass die Titan-Keimschicht 4 außerhalb der Leiterbahnen 10 nun offen liegt. In den vormals von den strukturierten Photoresist 8 bedeckten Bereichen wird nun die Titan-Keimschicht mittels Ätzen entfernt, wobei zum Ätzen der Titan-Keimschicht 4 Phosphorsäure verwendet wird, so dass ein zum Kupfermaterial der Leiterbahnen 10 selektives Ätzen durchführbar ist. Eine derartige Vorgehensweise erzeugt deutlich weniger Hinterschneidungen, so dass geringere Leiterbahnenbreiten sowie Abstände der Leiterbahnen zueinander erreicht werden können.

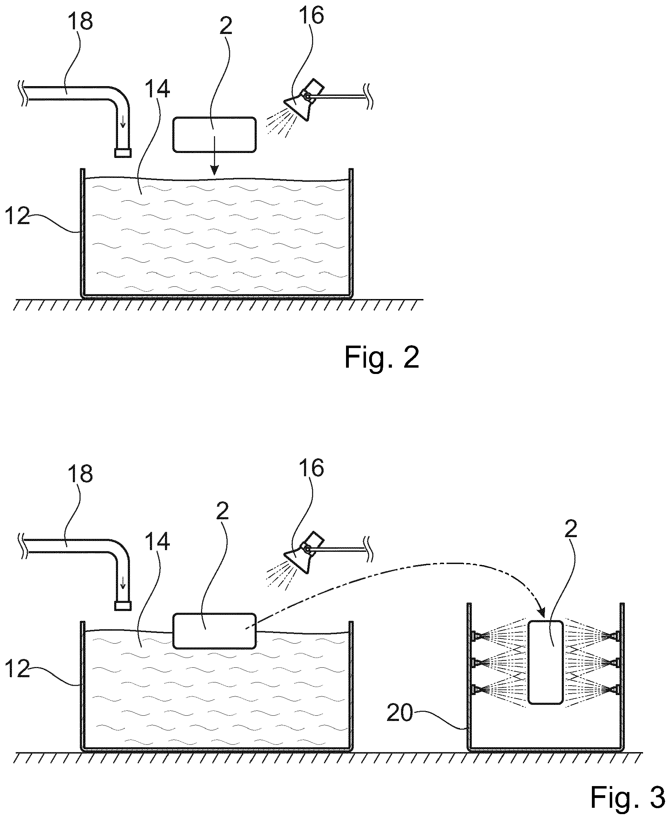

Unter Bezugnahme auf Figur 2 wird insbesondere der bei der Figur 1F gezeigte Ätzschritt nochmals erläutert. Man erkennt, dass das Substrat 2 in ein Tauchbecken 12 gegeben wird, wobei das Substrat dabei sowohl ruhen kann als auch im Tauchbecken 12 bewegt werden kann. In einer anderen, nicht in Figur 2 gezeigten Variante wäre auch ein Besprühen der Oberfläche des Substrats mit der Phosphorsäure möglich.

Die Phosphorsäure liegt mit einer vorgegebenen Konzentration als eine wässrige Lösung vor, was in Figur 2 anhand des Flüssigkeitsstandes zu erkennen ist, der mittels des Bezugszeichens 14 angedeutet ist. Zusätzlich wird beim Ätzvorgang der Titan-Keimschicht 4 UV-Licht mittels einer UV-Lampe 16 zugeführt, die beispielsweise UV-Licht mit einer Wellenlänge von 185 nm, 254 nm oder einer Kombination dieser beiden Wellenlängen emittieren kann.

Aufgabe dieser Bestrahlung mit UV-Licht aus der UV-Lampe 16 ist es, Sauerstoff bzw. Ozon in der Ätzlösung zu generieren. Desweiteren bewirkt das UV-Licht eine Aktivierung des Titans, insbesondere durch Oxidation zu Titanoxid, was eine direkte chemische Reaktion in der Diffusionsschicht ermöglicht, so dass sich die Notwendigkeit des Lösungsmittelaustauschs minimiert. Desweiteren unterstützt das UV-Licht ein Abspalten von OH aus der Phosphorsäure, so dass die abgespaltene OH-Gruppe das Ätzen von Titan unterstützt.

Gemäß der Erfindung kann die UV-Lampe 16 die Oberfläche des Substrats 2 direkt bestrahlen aber auch indirekt im Tauchbecken 12 eingesetzt werden, da auch dann trotzdem OH abspaltet und O2 oder O3 generiert wird. Die Wirkung ist beim indirekten Bestrahlen eventuell schlechter aber ausreichend für diese Anwendung. Unter dem Begriff "Belichtung mit UV-Licht" wird daher der Einsatz von UV-Lichts generell verstanden, unabhängig davon ob dies direkt auf die Oberfläche gerichtet ist oder nicht.

In Figur 3 ist eine weitere Ausführungsform der Erfindung gezeigt. Hier wird zusätzlich zur nasschemischen Ätzung in der Phosphorsäure noch ein Oxidationsmittel zugegeben, das entweder flüssig oder gasförmig als Wasserstoffperoxid, Sauerstoff oder Ozon zugeführt werden kann.

Die Zugabe des zusätzlichen Oxidationsmittels ist in Figur 3 schematisch durch die Zuführung 18 angedeutet. Aufgabe des Oxidationsmittels ist es, bei Neuansatz oder längerer Standzeit der Lösung mit der Phosphorsäure als Starter zu dienen. Desweiteren ist es aber auch möglich, das zusätzliche Oxidationsmittel zur Prozessbeschleunigung einzusetzen.

Anschließend wird, wie in Figur 3 durch die Spülvorrichtung 20 angedeutet ist, zur Steigerung der Prozesssicherheit ein Spülvorgang in einer Hochdruckspüle durchgeführt, um noch anhaftende Titanverbindungen lösen zu können. Dieser Prozessschritt ist typischerweise optional und wird je nach gewünschter Anwendung erforderlich sein.

Optional könnte mittels Ultraschalles in der Tauchanwendung Titan besser aus kleinen Strukturen gelöst werden. Speziell bei zyklischem Zu- und Abschalten sollte sich der Lösungsaustausch in ganz feinen Strukturen verbessern lassen.

In der Tauch- und Sprühanwendung könnte die Anbringung von zusätzlichen Saugeinrichtungen die Strömung und damit den Lösungsaustausch in ganz feinen Strukturen von Leiterbahnelementen 10 weiter verbessern. Die Kombination aus Spritzen bzw. Strömen (im Tauchen) und der Lösungsabsaugung generiert eine Strömung an der Oberfläche oder Strukturen und fördert den Lösungsaustausch.

Das im Zusammenhang mit den Figuren 1 bis 3 erläuterte Verfahren ist im Vergleich zu denjenigen aus dem Stand der Technik deutlich weniger gefährlich und wirkt insbesondere direkt an der zu ätzenden Oberfläche. Experimente haben gezeigt, dass Strukturelemente mit einer Auflösung von weniger als 2 µm damit realisierbar sind.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar.

### Liste der Bezugszeichen:

- 2: Substrat
- 4: Titan-Keimschicht
- 6: Photoresistschicht
- 8: Photoresist
- 10: Leiterbahnelemente
- 12: Tauchbecken
- 14: Flüssigkeitsstand
- 18: Zuführung
- 20: Spülvorrichtung

## Patentansprüche

1. Verfahren zum Strukturieren eines Substrats, insbesondere ein Strukturieren mittels selektiven Ätzens in der Halbleiter- und IC-Substratindustrie bei dem folgende Schritte ausgeführt werden
- Bereitstellen eines Substrats (2),
- Aufbringen einer Titan-Keimschicht (4) auf dem Substrat (2),
- vollflächiges Beschichten des Substrats (2) mit der Titan-Keimschicht (4) mit einer Photoresistschicht (6),
- lithografische Strukturierung der Photoresistschicht (6), um Bereiche der Titan-Keimschicht (6) freizulegen,
- selektives Aufbringen von Kupfer als Leiterbahnen (10) in diejenigen Bereiche, in denen die Titan-Keimschicht (4) freigelegt ist,
- Entfernen des strukturierten Photoresists (8), und
- Ätzen der Titan-Keimschicht (4) in den vormals von dem strukturierten Photoresist (8) bedeckten Bereichen, wobei zum Ätzen der Titan-Keimschicht (4) Phosphorsäure verwendet wird, und darüber hinaus während des Ätzens des Titans eine Belichtung mit UV-Licht erfolgt.

2. Verfahren nach Anspruch 1, bei dem die Titan-Keimschicht (4) eine Schichtdicke von 100 bis 300 nm aufweist und mittels eines Abscheidens aus der Gasphase, vorzugsweise mittels Sputtern erzeugt wird.

3. Verfahren nach Anspruch 1 oder 2, bei dem die Kupferschicht mittels Elektroplattieren aufgebracht wird.

4. Verfahren nach einem der Ansprüche 1 bis 3, bei dem das UV-Licht eine Wellenlänge von 300 nm oder weniger, bevorzugt 185 nm, 254 nm oder eine Kombination beider Wellenlängen, aufweist.

5. Verfahren nach einem der Ansprüche 1 bis 4, bei dem im Anschluss an das Ätzen ein Hochdruckspülvorgang angewendet wird.

6. Verfahren nach einem der Ansprüche 1 bis 5, bei dem das Ätzen der Titan-Keimschicht (4) durch ein Eintauchen in ein Becken mit Phosphorsäure oder durch Besprühen mit Phosphorsäure erfolgt.

7. Verfahren nach einem der Ansprüche 1 bis 6, bei dem ein zusätzliches Oxidationsmittel hinzugefügt wird.

8. Verfahren nach Anspruch 7, bei dem das Oxidationsmittel in flüssiger Form, vorzugsweise als Wasserstoffperoxid oder in Gasform, vorzugsweise als Sauerstoff oder Ozon hinzugefügt wird.

9. Verfahren nach einem der Ansprüche 7 oder 8, bei dem das Oxidationsmittel als Starter bei Neuansatz oder längerer Standzeit zugefügt wird.

10. Verfahren nach einem der Ansprüche 7 bis 9, bei dem das zusätzliche Oxidationsmittel zur Prozessbeschleunigung hinzugefügt wird.

11. Verfahren nach einem der Ansprüche 1 bis 10, bei dem zusätzlich eine Ultraschall-Behandlung durchgeführt wird.

12. Verfahren nach einem der Ansprüche 1 bis 11, bei dem das Lösungsmittel mit der Phosphorsäure einer Saugeinrichtung zugeführt wird.

## Claims

1. Method for structuring a substrate, in particular structuring by means of selective etching in the semiconductor and IC substrate industry, in which the following steps are carried out
- providing a substrate (2),
- applying a titanium seed layer (4) to the substrate (2),
- coating the entire surface of the substrate (2) having the titanium seed layer (4) with a photoresist layer (6),
- lithographic structuring of the photoresist layer (6) to expose regions of the titanium seed layer (6),
- selectively applying copper as conductor tracks (10) in the regions in which the titanium seed layer (4) is exposed,
- removing the structured photoresist (8), and
- etching the titanium seed layer (4) in the regions previously covered by the structured photoresist (8), wherein phosphoric acid is used to etch the titanium seed layer (4) and an exposure with UV light also takes place during the etching of the titanium.

2. Method according to claim 1, wherein the titanium seed layer (4) has a layer thickness of 100 to 300 nm and is produced by means of deposition from the gas phase, preferably by means of sputtering.

3. Method according to either claim 1 or claim 2, wherein the copper layer is applied by means of electroplating.

4. Method according to any of claims 1 to 3, wherein the UV light has a wavelength of 300 nm or less, preferably 185 nm, 254 nm or a combination of the two wavelengths.

5. Method according to any of claims 1 to 4, wherein a high-pressure flushing process is used following the etching.

6. Method according to any of claims 1 to 5, wherein the titanium seed layer (4) is etched by immersion into a basin of phosphoric acid or by spraying with phosphoric acid.

7. Method according to any of claims 1 to 6, wherein an additional oxidizing agent is added.

8. Method according to claim 7, wherein the oxidizing agent is added in liquid form, preferably as hydrogen peroxide, or in gaseous form, preferably as oxygen or ozone.

9. Method according to either claim 7 or claim 8, wherein the oxidizing agent is added as a starter in the case of a new batch or after a longer service life.

10. Method according to any of claims 7 to 9, wherein the additional oxidizing agent is added to accelerate the process.

11. Method according to any of claims 1 to 10, wherein an ultrasonic treatment is additionally carried out.

12. Method according to any of claims 1 to 11, wherein the solvent is supplied to a suction device together with the phosphoric acid.

## Revendications

1. Procédé de structuration d'un substrat, en particulier de structuration au moyen de gravure sélective dans l'industrie des semi-conducteurs et des substrats de circuits intégrés, dans lequel les étapes suivantes sont réalisées :
- fourniture d'un substrat (2),
- application d'une couche de germe de titane (4) sur le substrat (2),
- revêtement sur toute la surface du substrat (2) comportant la couche de germe de titane (4) avec une couche de photorésine (6),
- structuration lithographique de la couche de photorésine (6) afin d'exposer des zones de la couche de germe de titane (6),
- application sélective de cuivre en tant que pistes conductrices (10) dans les zones dans lesquelles la couche de germe de titane (4) est exposée,
- retrait de la photorésine structurée (8), et
- gravure de la couche de germe de titane (4) dans les zones précédemment couvertes par la photorésine structurée (8), de l'acide phosphorique étant utilisé pour graver la couche de germe de titane (4), et une exposition à la lumière UV ayant également lieu pendant la gravure du titane.

2. Procédé selon la revendication 1, dans lequel la couche de germe de titane (4) présente une épaisseur de couche de 100 à 300 nm et est produite par dépôt à partir de la phase gazeuse, de préférence par pulvérisation cathodique.

3. Procédé selon la revendication 1 ou 2, dans lequel la couche de cuivre est appliquée par dépôt galvanique.

4. Procédé selon l'une des revendications 1 à 3, dans lequel la lumière UV présente une longueur d'onde de 300 nm ou moins, de préférence de 185 nm, 254 nm ou une combinaison des deux longueurs d'onde.

5. Procédé selon l'une des revendications 1 à 4, dans lequel un processus de rinçage à haute pression est utilisé après la gravure.

6. Procédé selon l'une des revendications 1 à 5, dans lequel la couche de germe de titane (4) est gravée par immersion dans un bain d'acide phosphorique ou par vaporisation d'acide phosphorique.

7. Procédé selon l'une des revendications 1 à 6, dans lequel un agent d'oxydation supplémentaire est ajouté.

8. Procédé selon la revendication 7, dans lequel l'agent d'oxydation est ajouté sous forme liquide, de préférence sous forme de peroxyde d'hydrogène, ou sous forme gazeuse, de préférence sous forme d'oxygène ou d'ozone.

9. Procédé selon l'une des revendications 7 ou 8, dans lequel l'agent d'oxydation est ajouté comme amorceur lors d'une nouvelle préparation ou d'une plus longue période d'attente.

10. Procédé selon l'une des revendications 7 à 9, dans lequel l'agent d'oxydation supplémentaire est ajouté pour accélérer le processus.

11. Procédé selon l'une des revendications 1 à 10, dans lequel un traitement par ultrasons est également effectué.

12. Procédé selon l'une des revendications 1 à 11, dans lequel le solvant est amené, avec l'acide phosphorique, à un dispositif d'aspiration.
